Europäisches Patentamt

European Patent Office

Office européen des brevets

(11) Publication number: **0 102 988**
**B1**

(12) **EUROPEAN PATENT SPECIFICATION**

(45) Date of publication of patent specification: 21.09.88

(21) Application number: 83900878.6

(22) Date of filing: 31.01.83

(86) International application number:
PCT/US83/00140

(87) International publication number:
WO 83/03164 15.09.83 Gazette 83/21

(51) Int. Cl.⁴: **H 01 L 23/48,** H 01 L 29/44,
H 01 L 29/52

(54) INTEGRATED CIRCUIT LEAD FRAME.

(30) Priority: 08.03.82 US 355993

(43) Date of publication of application:
21.03.84 Bulletin 84/12

(45) Publication of the grant of the patent:
21.09.88 Bulletin 88/38

(84) Designated Contracting States:
DE FR GB NL

(56) References cited:
CH-A- 539 947
US-A-3 762 039
US-A-3 839 782
US-A-3 842 492
US-A-4 209 355
US-A-4 234 666
US-A-4 301 464
US-A-4 312 926
US-A-4 331 740

(73) Proprietor: MOTOROLA, INC.
1303 East Algonquin Road
Schaumburg, Illinois 60196 (US)

(72) Inventor: BOND, Richard J.
5115 N. 40th Street Apt. A120
Phoenix, AZ 85018 (US)

(74) Representative: Ibbotson, Harold
Motorola Ltd Jays Close Viables Industrial
Estate
Basingstoke Hants RG22 4PD (GB)

(56) References cited:
PATENTS ABSTRACTS OF JAPAN, vol. 5, no.
129 (E-70) 801r, August 19, 1981; & JP - A - 56
67 951 (MITSUBISHI DENKI K.K.) 08-06-1981
PATENTS ABSTRACTS OF JAPAN, vol. 5, no.
40 (E-49)712r, March 17, 1981; & JP - A - 55 163
866 (FUJITSU K.K.) 20-12-1980

Courier Press, Leamington Spa, England.

(56) References cited:
PATENTS ABSTRACTS OF JAPAN, vol. 6, no. 132 (E-119)1010r, July 17, 1982; & JP - A - 57 58 342 (HITACHI SEISAKUSHO K.K.) 08-04-1982
PATENTS ABSTRACTS OF JAPAN, vol. 6, no. 170 (E-128)1048r, September 3, 1982; & JP - A - 57 88 753 (HITACHI SEISAKUSHO K.K.) 02-06-1982
PATENTS ABSTRACTS OF JAPAN, vol. 7, no. 194 (E-195)1339r, August 24, 1983; & JP - A - 58 95 852 (MATSUSHITA DENSHI KOGYO K.K.) 07-06-1983
PATENTS ABSTRACTS OF JAPAN, vol. 7, no. 154 (E-185)1299r, July 6, 1983; & JP - A - 58 64 056 (NIPPON DENKI K.K.) 16-04-1983

## Description

This invention relates generally to lead frames and more particularly to lead frames for use in plastic encapsulation of integrated circuits.

Although there are substantial cost savings for the plastic encapsulation of integrated circuits over ceramic encapsulation, ceramic packages have an advantage of providing a hermetic seal. With plastic packages, fluid-borne contaminants, such as chlorine, can infiltrate the plastic package along the plastic-lead interface to the wire bonding post. The contaminants then migrate along the surface of the bond wire to the bonding pad of the integrated circuit. The resulting corrosion of the aluminum bonding pad eventually causes an open circuit.

One attempt to solve this long standing problem with plastic packages required that the integrated circuit be covered with a water resistant coating prior to encapsulation, thus requiring an additional step in the packaging process.

CH-A-539947 discloses a lead frame for producing an encapsulated integrated circuit in which perforations are provided in the leads within the encapsulated area to secure the leads to the plastic package.

Patents abstract of Japan, Vol. 5, No. 129, (E-70), 19 August 1981 discloses an encapsulated integrated circuit device having a major and a minor axis, said axes mutually orthogonal and coplanar, a die mounting portion positioned generally symmetrically relative to said major and minor axes and having an integrated circuit die mounted thereon, a first plurality of leads having an encapsulation line intermediate the ends of said leads, and a material encapsulating the die mounting portion and a portion of the first plurality of leads to the encapsulation line on said leads, said leads extending substantially parallel to said minor axis from a proximal end adjacent one side of said mounting portion and generally coplanar therewith to at least the encapsulation line, each of said leads having a top surface and a bottom surface with a groove formed in the top surface, the groove being parallel to the major axis.

The present invention seeks to provide a lead frame for use in plastic encapsulation of an integrated circuit which provides improved resistance against infiltration of contaminants into the integrated circuit.

The above object is achieved in the integrated circuit of the invention according to claim 1 in which each lead has at least one groove formed in the bottom surface, each groove being parallel to the major axis and the grooves in the top and bottom surface of each of the leads are in the portion of the lead between the proximal end and the encapsulation line.

FIG. 1 is an illustration of an integrated circuit lead frame according to an embodiment of the present invention.

FIG. 2 is a cross section of one of the leads used in the embodiment of FIG. 1.

FIG. 3 is an illustration of an integrated circuit lead frame according to a second embodiment of the present invention.

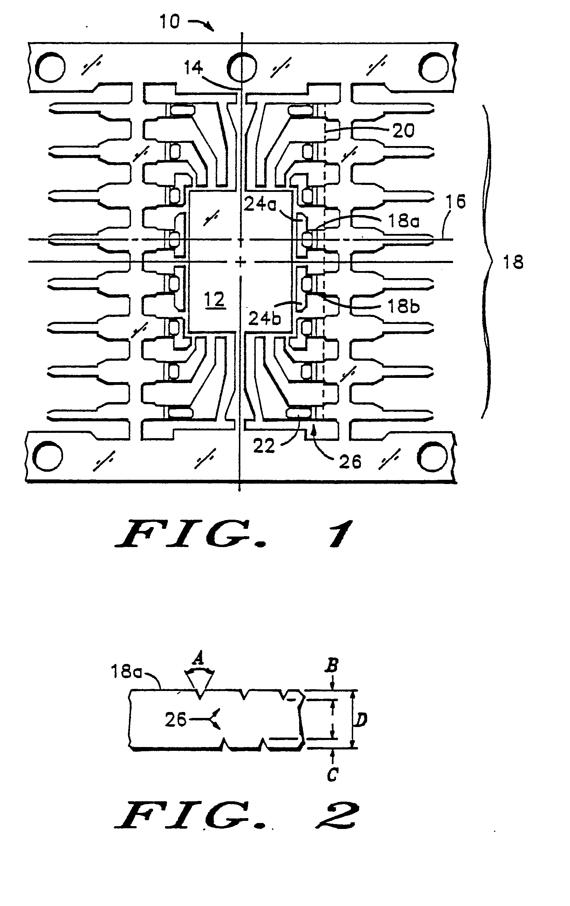

Shown in FIG. 1 is an integrated circuit lead frame 10 of the present invention comprised generally of an integrated circuit die mounting flag 12 positioned generally symmetrically relative to the major and minor axes 14 and 16, respectively, of the lead frame 10, and a plurality of leads 18, each of which extends, at least in part, parallel to minor axis 16 from a proximal end adjacent a respective side of the flag 12 and generally coplanar therewith to at least an encapsulation line 20. In use, an integrated circuit die (not shown) is attached to the flag 12 and the bonding pads thereof connected by fine wires to respective bonding portions formed on the proximal ends of the leads 18. In some circumstances, it may be desirable to displace the flag 12 somewhat below the plane of the leads 18 to facilitate the wire bonding operation. Even if there is such a displacement, the plane of the leads 18, although not precisely coplanar, will be generally coplanar with flag 12. The die and the portions of the leads 18 within the encapsulation line 20 are then encapsulated in a suitable plastic compound.

In the preferred form, each of the leads 18 has a perforation 22 extending orthogonal to the major and minor axes 14 and 16, respectively, through the portion thereof near the encapsulation line, to allow the encapsulation plastic to more securely anchor the lead 18 in place. It has been discovered, however, that a significant reduction in the likelihood of infiltration of fluid-borne contaminants may be obtained if the dimension of the perforation 22 parallel to the major axis 14 is selected to minimize the surface area of the lead 18 along which infiltration of such contaminants can progress from the encapsulation line 20 to the wire bonding site, without jeopardizing the strength of the respective lead 18. In addition, it has been discovered that the shortest of the leads 18 are most susceptible to contaminant damage. Accordingly, the proximal ends of leads 18a and 18b have respective bonding posts 24a and 24b extending substantially parallel to the major axis 14 from one edge of the respective leads 18a and 18b a substantial lateral distance therefrom to further retard infiltration by increasing the distance between the point of ingress of contaminants at the encapsulation line 20 and the wire bonding sites at the ends of the bonding posts 24a and 24b.

Although the combination of the perforations 22 and the bonding posts 24a and 24b provides a significantly improved resistance to contamination damage, the preferred embodiment is greatly improved by providing a plurality of grooves on the upper and lower surfaces of each of the leads 18 generally parallel to the major axis 14 between the perforations 22 and the encapsulation line 20. For example, in the cross section of the lead 18a shown in FIG. 2, three grooves 26 are provided on the top surface and two grooves on the bottom surface of the leads 18, with each groove being formed at an angle A of 90° at a depth B and C of 0.003048 ± 0.000508 cm (.0012 ± .0002 inches). Lead 18a has a thickness D of 0.0254 ± 0.0001016 cm (.0100 ± .0004 inches).

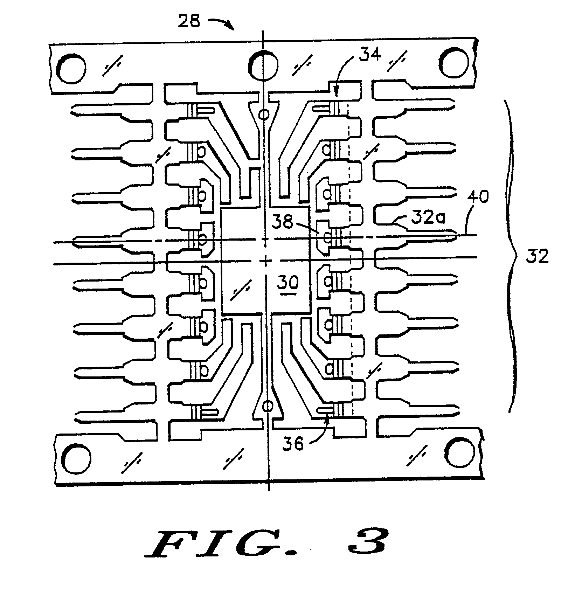

Shown in FIG. 3 is an integrated circuit lead frame 28 comprised generally of a flag 30 and a plurality of leads 32 configured similar to lead frame 10 of FIG. 1 with grooves 34 and perforations 36. Using a single lead 32a as an example, lead 32a has a bonding portion 38 at an end proximal flag 30 substantially along longitudinal axis 40 of lead 32a. In use an integrated circuit die is bonded to flag 30 and electrically connected via fine wire to leads 32 at, in the case of example lead 32a, bonding portion 38. Having bonding portion 38 directly behind a perforation 36 effectively interposes perforation 36 as a physical impediment in the path of contaminants.

## Claims

1. An encapsulated integrated circuit device having a major and a minor axis, said axes mutually orthogonal and coplanar, a die mounting portion positioned generally symmetrically relative to said major and minor axes and having an integrated circuit die mounted thereon, a first plurality of leads having an encapsulation line intermediate the ends of said leads, and a material encapsulating the die mounting portion and a portion of the first plurality of leads to the encapsulation line on said leads, said leads extending substantially parallel to said minor axis from a proximal end adjacent one side of said mounting portion and generally coplanar therewith to at least the encapsulation line, each of said leads having a top surface and a bottom surface with a groove formed in the top surface, the groove being parallel to the major axis, characterized in that:
  each lead has at least one groove formed in the bottom surface, each groove being parallel to the major axis, and in that the grooves in the top and bottom surface of each of the leads are in the portion of the lead between the proximal end and the encapsulation line.

2. The encapsulated integrated circuit device of claim 1 wherein each of said leads includes a perforation located between the proximal end and the encapsulation line and extending orthogonal to said axes through said leads.

3. The encapsulated integrated circuit device of claim 2 wherein each of said leads has a plurality of grooves in the top surface and a plurality of grooves in the bottom surface.

4. The encapsulated integrated circuit device of claim 3 wherein each of said leads has a bonding area between the perforation and the proximal end near the axis of the lead.

5. The encapsulated integrated circuit device of claim 3 wherein each of said proximal ends includes a bonding post extending substantially parallel to said major axis from one edge of said lead a substantial lateral distance therefrom.

## Patentansprüche

1. Vergossene integrierte Schaltungsanordnung mit einer Hauptachse und einer Nebenachse, die aufeinander senkrecht stehen und koplanar sind, einem Chipmontageabschnitt, der im wesentlichen symmetrisch in bezug auf die Haupt- und Nebenachsen angeordnet ist und ein darauf befestigtes integriertes Schaltungschip trägt, einer ersten Vielzahl von Leitern, die eine Vergußlinie zwischen den Enden der genannten Leiter aufweisen, und einem Material, das den Chipmontageabschnitt und einen Teil der ersten Vielzahl von Leitern bis zur Vergußlinie auf den Leitern eingießt, wobei sich die Leiter im wesentlichen parallel zu der Nebenachse von einem nahen Ende benachbart einer Seite des genannten Montageabschnitts und im wesentlichen koplanar damit bis zu wenigstens der Vergußlinie erstrecken und jeder der Leiter eine Oberseite und eine Unterseite mit einer Rille in der Oberseite aufweist, die parallel zur Hauptachse verläuft, dadurch gekennzeichnet, daß jeder Leiter wenigstens eine Rille in der Unterseite aufweist, daß jede Rille parallel zu der Hauptachse verläuft und daß die Rillen in der Oberseite und in der Unterseite eines jeden der Leiter sich in dem Abschnitt des Leiters befinden, der zwischen dem nahen Ende und der Vergußlinie liegt.

2. Vergossene integrierte Schaltungsanordnung nach Anspruch 1, bei der jeder der Leiter einen Durchbruch aufweist, der zwischen dem nahen Ende und der Vergußlinie liegt und sich senkrecht zu den genannten Achsen durch den Leiter erstreckt.

3. Vergossene integrierte Schaltungsanordnung nach Anspruch 2, bei der jeder der genannten Leiter mehrere Rillen in der Oberseite und mehrere Rillen in der Unterseite aufweist.

4. Vergossene integrierte Schaltungsanordnung nach Anspruch 3, bei der jeder der genannten Leiter einen Verbindungsbereich zwischen dem Durchbruch und dem nahen Ende nahe der Achse des Leiters aufweist.

5. Vergossene integrierte Schaltungsanordnung nach Anspruch 3, bei der jedes der genannten nahen Enden einen Verbindungsstiel aufweist, der sich im wesentlichen parallel zu der genannten Hauptachse von einem Rand des genannten Leiters um eine im wesentlichen querlaufende Distanz davon erstreckt.

## Revendications

1. Dispositif à circuit intégré encapsulé possédant un axe majeur et un axe mineur, lesdits axes étant mutuellement perpendiculaires et coplanaires, une partie de montage de puce disposée sensiblement symétriquement par rapport auxdits axes majeur et mineur, sur laquelle est montée une puce à circuit intégré, une première pluralité de conducteurs de montage possédant une ligne d'encapsulation située entre les extrémités desdits conducteurs de montage, et un matériau encapsulant la partie de montage de

puce et une partie de la première pluralité de conducteurs de montage allant jusqu'à la ligne d'encapsulation sur lesdits conducteurs, lesdits conducteurs de montage étant orientés sensiblement parallèlement audit axe mineur et s'étendant depuis une extrémité proximale adjacente à un côté de ladite partie de montage et sensiblement coplanaire avec celle-ci jusqu'à, au moins, la ligne d'encapsulation, chacun desdits conducteurs de montage possédant une surface supérieure et une surface inférieure, une entaille étant formée dans la surface supérieure, cette entaille étant parallèle à l'axe majeur, caractérisé en ce que:

chaque conducteur de montage possède au moins une entaille formée dans la surface inférieure, chaque entaille étant parallèle à l'axe majeur, et en ce que les entailles formées dans la surface supérieure et inférieure de chacun des conducteurs de montage se trouvent dans la partie du conducteur de montage située entre l'extrémité proximale et la ligne d'encapsulation.

2. Dispositif à circuit intégré encapsulé selon la revendication 1, où chacun desdits conducteurs de montage comporte une perforation placée entre l'extrémité proximale et la ligne d'encapsulation et s'étendant orthogonalement auxdits axes à travers lesdits conducteurs de montage.

3. Dispositif à circuit intégré encapsulé selon la revendication 2, où chacun desdits conducteurs de montage possède une pluralité d'entailles dans la surface supérieure et une pluralité d'entailles dans la surface inférieure.

4. Dispositif à circuit intégré encapsulé selon la revendication 3, où chacun desdits conducteurs de montage possède une aire de liaison entre la perforation et l'extrémité proximale proche de l'axe du conducteur de montage.

5. Dispositif à circuit intégré encapsulé selon la revendication 3, où chacune desdites extrémités proximales comporte une borne de liaison s'étendant sensiblement parallèlement audit axe majeur depuis un bord dudit conducteur de montage sur une distance latérale notable de celui-ci.

FIG. 1

FIG. 2

1

FIG. 3